# EUROPEAN PATENT APPLICATION

(11) **EP 0 916 956 A1**
(43) Date of publication of application: **19.05.1999**
(21) Application number: 98308738.8
(22) Date of filing: 26.10.1998
(51) Int. Cl.: G01R 19/02

(54) **RMS converter for obtaining fast RMS measurements**

(30) Priority: 10.11.1997 US 967007
(71) Applicant: FLUKE CORPORATION, Everett, Washington 98206-9090 (US)
(72) Inventor: Huber, Clark N., Everett, Washington 98203 (US)
(74) Representative: Burke, Steven David

(57) **Abstract**

An rms (root mean square) converter for obtaining fast rms measurements of power line signals having a frequency of either 50 Hertz or 60 Hertz is provided. The digital samples of the power line frequency signal that arrive at the rms converter are squared and summed in an averaging circuit At the end of each rms measurement period, an average value is provided to a square root circuit which calculates the rms value. The rms measurement period has been chosen to be 50 milliseconds to span the minimum integer number of cycles of the squared of the power line signal, either six cycles for the 60 Hertz frequency or five cycles for the 50 Hertz frequency, to provide rms values at a rate up to 20 rms values per second.

## Description

### Background of the Invention

This invention relates generally to root mean square (rms) converter circuits and in particular to a circuit and method for obtaining fast rms measurements of power line signals.

Multimeters and voltmeters typically provide a.c. (alternating current) voltage measurements in terms of volts rms. Power line signals are the a.c. voltages, typically 120 V or 240 V rms, provided by the electric power utility to consumers and industry. The ability to determine the rms value of power linesignals with high accuracy and reliability is of great importance in test and measurement applications but is often obtained at the expense of measurement speed, with measurement periods spanning multiple cycles of the input signal to obtain the rms value.

Early multimeters used diode rectifiers and capacitor averaging circuits to provide analog rms measurements with adequate accuracy of power line signals having a known frequency and a generally sinusoidal waveshape. Such readings required averaging over multiple cycles of the signal in order to obtain a stable reading with a minimum of a.c. ripple voltage imposed on the d.c. voltage that represents the rms value.

Analog rms to d.c. converters improve on the limitations of the diode averaging by producing a "true-rms" value in the form of a d.c. voltage for signals having a much wider variety of waveshapes. Thermal rms converters are a type of rms converter that operates by applying a signal to a resistor in a thermally isolated environment and measuring the equivalent thermal rise in the resistor temperature to obtain an equivalent d.c. heating value corresponding to rms. Because thermal rms converters measure the equivalent d.c. heating value according to the thermal response of the resistor, the time to obtain a stable measurement will span many cycles of the input signal, with the measurement time depending on the thermal characteristics of the resistor, the ambient temperature, and the required accuracy of the rms measurement, among other factors.

Monolithic rms converters are still another type of rms converter that is constructed with analog circuits such as amplifiers, multipliers, dividers, and integrators within a single integrated circuit to obtain a d.c. voltage that represents the rms value. The rms value is determined over a predetermined averaging time which is set according to the desired level of accuracy and the maximum amount of a.c. ripple that may be imposed on the d.c. signal that represents the rms value. For 50 Hertz and 60 Hertz power line signals, the averaging period necessarily spans many cycles.

Analog-to-digital converters (ADCs), which had formerly been placed behind the analog rms converters to convert the d.c. voltage representing the rms value into digital samples, are now commonly replacing analog rms converters in newer instrument designs to measure input signals at the front end. ADCs now provide higher sampling rates and measurement accuracy that allow for sampling the input signal directly and storing the digital samples as a time record for further processing. Mathematical operations are used to integrate the digital samples over a predetermined number of digital samples from the time record and then calculate the rms value of the signal. Because the exact period of the signal may not be known, the time record spans multiple cycles of the signal in order to obtain the desired level of accuracy.

In pending U.S. Application 08/840,086, "FRONT-END ARCHITECTURE FOR A MEASUREMENT INSTRUMENT", to Steven D. Swift, and assigned to Fluke Corporation, a front end architecture for a measurement instrument is disclosed in which the input signal is conditioned by a front end circuit and digitized by an ADC to produce digital samples. The digital samples are provided to a set of digital extraction filters for simultaneous extraction of various measurement parameters, including rms values and peak minimum and maximum values. The length and complexity of the digital filters are determined by the desired characteristics of the various transfer functions. The front end architecture may be adapted measuring for a wide variety of signals but provides no teaching regarding how to obtain fast rms measurements of power line signals.

In pending U.S. Application 08/802,020, "RMS CONVERTER USING DIGITAL FILTERING", to Swift et al. and assigned to Fluke Corporation, an rms converter implemented as a squaring circuit followed by a digital filter and square root circuit is described. The rms value is obtained from the continuous stream of digital samples without regard to the period of the input signal and with no predetermined integration period. Because the transfer function of the digital filter is modeled after the thermal response of the physical resistor in the thermal rms converter discussed above, the response time to obtain an rms value is driven by the accuracy requirement of the measurement application. The problem of obtaining rms values at fast measurement rates for signals having known periods such as a power line signal is not addressed.

RMS measurements according to the prior art are thus performed at relatively slow rates in order to obtain acceptable accuracy over a wide range of possible input periods. Such rates are not always adequate for many troubleshooting applications where higher rms measurement rates are required to detect intermittent problems. In test and measurement applications oriented to measurements of signals at world-wide standard power line frequencies of 50 Hertz and 60 Hertz, the period of the power line signal is known to be one of two distinct periods. Therefore, it would be desirable to provide an rms converter that performs fast rms measurements to obtain measurement rates substantially faster than prior art techniques for power line signals by taking advantage of the known periods of the power line signal.

### Summary of the Invention

In accordance with the present invention, an rms converter for obtaining fast rms measurements of power line signals is provided. The power line frequency signal is a periodic sine wave with a frequency that is either 50 Hertz or 60 Hertz according to worldwide standards. It is desirable for troubleshooting and diagnosis purposes that rms values of the power line frequency signal be produced at the fastest rate possible.

The rms converter according to the present invention takes advantage of having known power line frequencies and waveforms to provide fast rms measurements at the minimum measurement period of 50 milliseconds (ms) which accommodates either 50 Hertz or 60 Hertz to obtain a measurement rate of 20 rms measurements per second.

In a measurement instrument containing the rms converter, the signal being measured ("input signal") is coupled via a front end which provides a conditioned input signal to a sampling system, typically in the form of an analog to digital converters (ADCs), sigma delta converters, or other digital sampling technologies known in the art to provide digital samples of an analog signal. Digital samples from the sampling system are provided at a sample rate and resolution substantially high enough to provide a desired level of accuracy over the 50 ms rms measurement period. In the preferred embodiment, digital samples are provided by the sampling system at a sample rate of 1,000 samples per second with eight bit amplitude resolution.

The digital samples that arrive at the rms converter are squared in a squaring circuit and summed in an averaging circuit At the end of each rms measurement period, an average value is provided to a square root circuit which calculates the rms value. The rms value is then provided to microprocessor for further processing which may include storing minimum and maximum rms values or creating a graphical plot of the rms values over time. The rms measurement period has been chosen to be 50 ms to span the minimum integer number of cycles of the squared power line signal for both 50 Hertz and 60 Hertz frequencies. The 50 ms rms measurement period spans six cycles for the 60 Hertz frequency and five cycles for the 50 Hertz frequency to provide a fast rms measurement with a maximum rate of 20 rms values per second.

One object of the present invention is to provide a method for obtaining fast rms measurements.

Another object of the present invention is to provide an rms converter for obtaining fast rms measurements of power line frequency signals.

An additional object of the present invention is to provide a method of producing fast rms measurements that accommodates either 50 Hertz or 60 Hertz power line frequency signals.

A further object of the present invention is to provide a measurement instrument which produces fast rms measurements of power line frequency signals.

Other features, attainments, and advantages will become apparent to those skilled in the art upon a reading of the following description when taken in conjunction with the accompanying drawings.

### Brief Description of the Drawings

FIG. 1 is a simplified block diagram of a measurement instrument for producing fast rms measurements of power line signals according to the present invention;
FIG. 2 is a graph showing the relationship between the power line signal of 60 Hertz and an rms measurement period;
FIG. 3 is a graph showing the relationship between the power line signal of 50 Hertz and the rms measurement period;
FIG. 4 is a graph showing the creation of fast rms measurements from the power line signal according the rms measurement period; and
FIG. 5 is a simplified block diagram of the rms converter according to the present invention.

### Detailed Description of the Invention

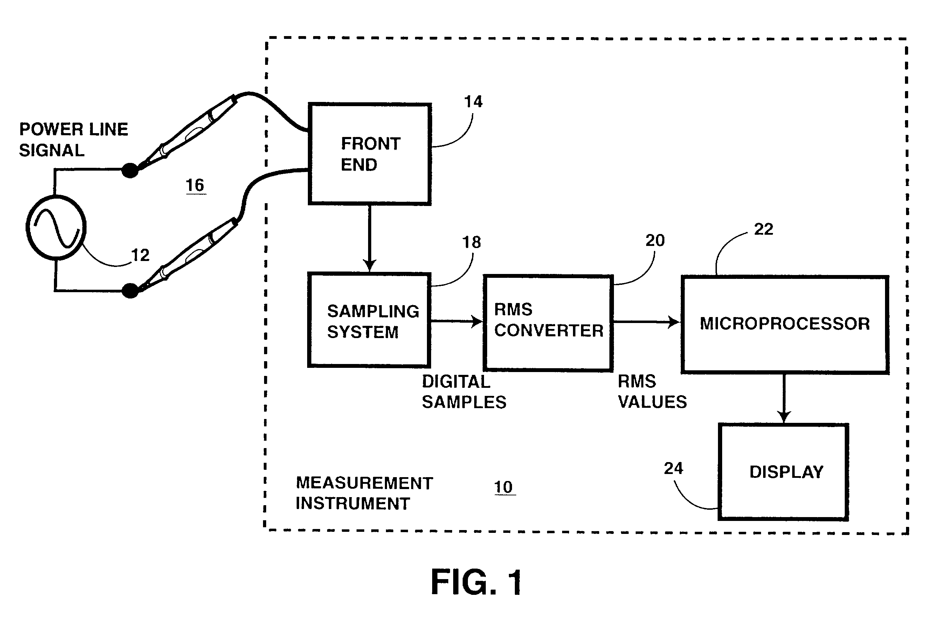

FIG. 1 is a simplified block diagram of a measurement instrument 10 adapted for producing fast rms measurements of power line signals. The measurement instrument 10 is coupled to a voltage source 12 which models the power line frequency signals encountered in typical test and measurement applications. The power line signal is a periodic sine wave with a frequency that is either 50 Hertz or 60 Hertz according to worldwide electrical power standards. It is desirable for troubleshooting and diagnosis purposes that rms values of the power line signal be produced at the fastest rate possible. The rms values thus generated can be stored, captured in terms of minimum and maximum values, or plotted on a graphical display for further analysis, such as to detect short-term anomalies.

The voltage source 12 is coupled to a front end 14 via a pair of test probes 16. The front end circuit 14 receives the voltage across the pair of test probes 16 as an input voltage. Because the input voltage may be of an unknown level and have other frequency or noise components present, the front end circuit 14 provides for signal conditioning circuitry, including over-voltage protection circuits, amplifiers, filters, and dividers, to provide a conditioned input signal of suitable amplitude level and input bandwidth for conversion to digital samples.

The conditioned input signal is provided to a sampling system 18 which converts the conditioned input signal into a stream of digital samples which are provided to an rms converter 20. The sampling system 18 may be implemented as an analog-to-digital converter (not shown) or with a sigma delta converter and decimation filter (not shown), or other sampling technologies known in the art. The sample rate of the sampling system may be chosen at a rate high enough to obtain the required accuracy of the rms measurement and the input bandwidth of the measurement instrument 10. In the preferred embodiment, the sample parameters of 1,000 samples per second sample rate and 8 bit amplitude resolution were chosen to obtain the desired accuracy level of the rms value.

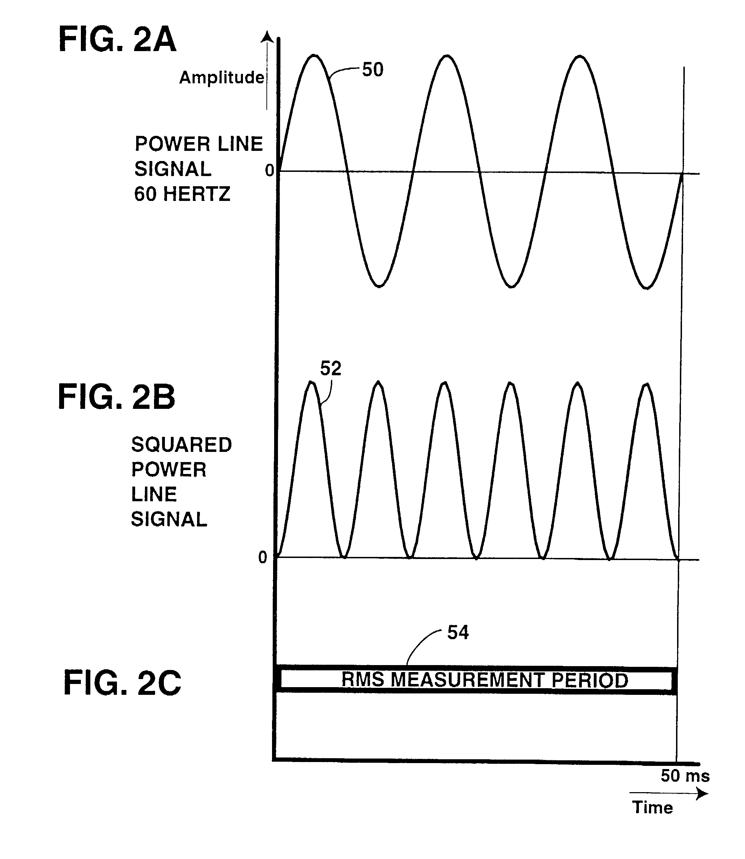

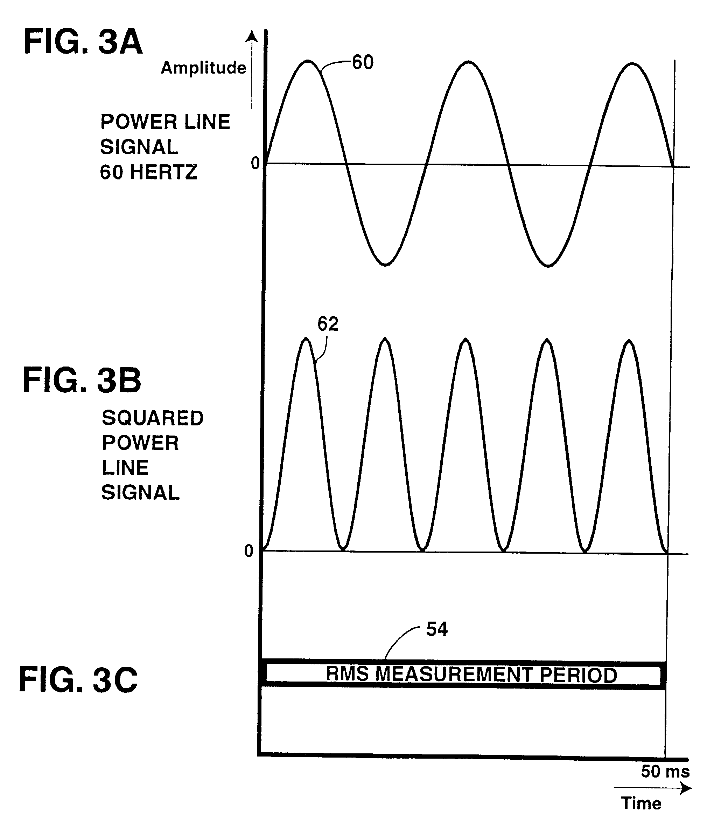

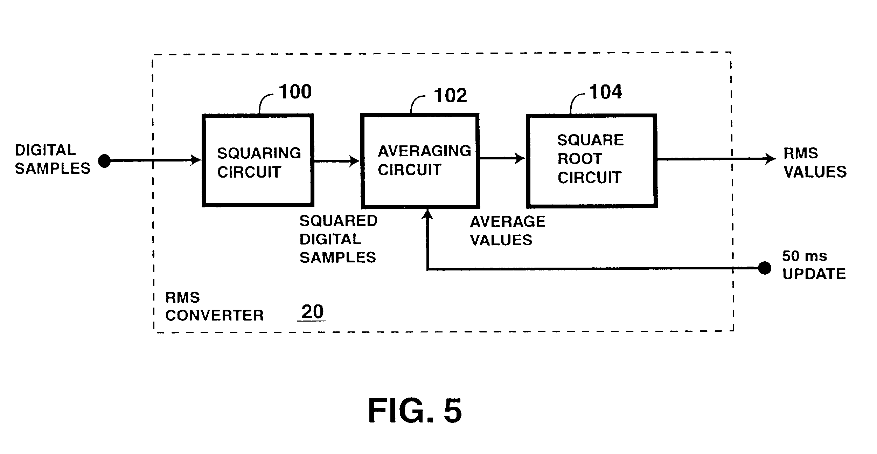

The rms measurement period of 50 milliseconds was chosen as the minimum measurement period that will accommodate both 60 Hertz and 50 Hertz frequency power line signals without alteration to provide rms measurements at the highest possible rate of 20 rms values per second. The relationship between the rms measurement period and the power line signal for 60 Hertz and for 50 Hertz is demonstrated in FIG. 2 and in FIG. 3. The rms measurement period of 50 ms is chosen to span a minimum integer number of cycles of the square of the power line signal, either 6 cycles as shown in FIG. 2B or 5 cycles as shown in FIG. 3B, that is compatible with both 50 and 60 Hertz frequency power line signals without change.

In FIG. 2A there is shown an amplitude versus time graph of the power line signal with a frequency of 60 Hertz drawn as trace 50 of a periodic sine wave as might be displayed on a conventional oscilloscope. The trace 50 is labeled POWER LINE SIGNAL 60 HERTZ and represents the amplitude values that appear as digital samples. Because 60 Hertz frequency power line signals are normally very close to 60 Hertz, the period of three full cycles of the sine wave will be very close to 50 ms. In FIG. 2B, there is shown a trace 52 of the square of the power line signal of FIG. 2A which is labeled SQUARED POWER LINE SIGNAL. The trace 52 represents the amplitude values of squared digital samples produced in the rms converter 20. Taking the square of the power line signal effectively doubles its frequency so that six complete cycles appear in the trace 52. In FIG. 2C there is shown an rms measurement period 54 which spans 50 milliseconds in the preferred embodiment. Because the rms measurement period 54 spans six integer cycles of the squared digital samples as shown in the trace 52, the phase of the power line frequency input signal relative to the rms measurement period does not affect the resulting calculation of the rms value. In this way, the rms measurement period 54 does not have to be synchronized or triggered to begin at any particular phase of the power line frequency input signal, which greatly simplifies the measurement process.

In FIG. 3A there is shown an amplitude versus time graph of the power line signal similar to that of FIG. 2A, but with a frequency of 50 Hertz drawn as trace 60 which is labeled POWER LINE SIGNAL 50 HERTZ. The trace 60 represents the amplitude values that in the form of digital samples. Because 50 Hertz frequency power line signals are normally very close to 50 Hertz, the period of two and one half full cycles of the sine wave will be very close to 50 ms. In FIG. 3B, there is shown a trace 62 which is the square of the power line signal of FIG. 3A which is labeled SQUARED POWER LINE SIGNAL and in the form of squared digital samples. Taking the square of the power line signal effectively doubles its frequency so that five complete cycles appear in the trace 62. In FIG. 3C there is shown the rms measurement period 54 (also shown in FIG. 2C). Because the rms measurement period 54 includes five integer number of cycles of the squared digital samples as shown in the trace 62, the phase of the power line frequency input signal relative to the rms measurement period 54 does not affect the resulting calculation of the rms value. The rms measurement period 54 is thus the shortest possible period that allows an integer number of cycles, either six or five, of the traces 52 and 62 for the square of the power line signal of 60 Hertz and 50 Hertz respectively.

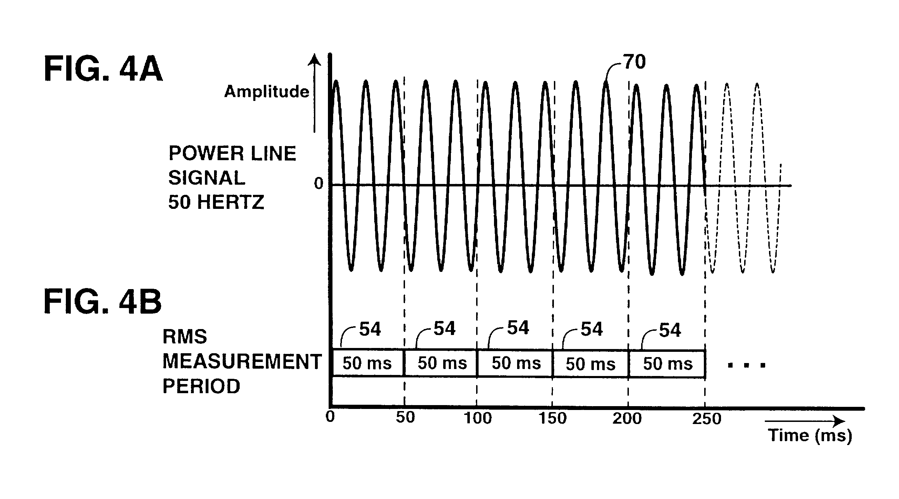

In FIG. 4A there is shown an amplitude versus time graph of the power line signal with a frequency of 50 Hertz (shown in FIG. 3A) now drawn as a trace 70 over an extended number of cycles. Multiple rms measurement periods 54, one following the other, are performed to produce rms values at the time values of 50 ms, 100 ms, 150 ms, and so on to obtain an rms measurement rate of 20 rms values per second. Alternatively, the rms measurement periods need not follow each other exactly and need not maintain precisely the same starting phase relationship with each other as long as the relationship between the rms measurement period and the number of cycles of the power line signal remains substantially the same, either two and one half cycles for a 50 Hertz frequency input signal and three cycles for a 60 Hertz frequency input signal.

In FIG. 5, there is shown a simplified block diagram of the rms converter 20 according to the present invention. The digital samples generated by the sampling system 18 (shown in FIG. 1) arrive at the rms converter 20. Each of the digital samples is squared in a squaring circuit 100 to obtain squared digital samples representing the square of the power line signal which are then provided to an average circuit 102. The average circuit 102 accumulates the squared digital samples and, upon receipt of an update signal which arrives every 50 ms, the average circuit 102 calculates an average value from the digital samples accumulated over the rms measurement period 54. A square root circuit 104 then calculates the square root of the average value to produce the rms value.

It will be obvious to those having ordinary skill in the art that many changes may be made in the details of the above described preferred embodiments of the invention without departing from the spirit of the invention in its broader aspects. For example, the rms converter 20 may be implemented in hardware using dedicated digital circuits, in software as executed by a microprocessor, or a combination thereof according to the requirements of the application. Longer rms measurement periods may be chosen, for example 100 ms, that maintain an integer number of cycles of the squared digital samples to obtain improved resolution of the average value. If only one power line frequency or the other need be measured with no accommodation for the other, a shorter rms measurement period may be chosen to obtain rms values at a higher measurement rate than 20 rms values per second. Therefore, the scope of the present invention should be determined by the following claims.

## Claims

1. An rms converter comprising:
(a) a squaring circuit for receiving a power line signal to produce squared digital samples;
(b) an averaging circuit coupled to said squaring circuit to provide an average value of said squared digital samples over an rms measurement period wherein said rms measurement period spans an integer number of cycles of said squared digital samples; and
(c) a square root circuit for calculating the square root of said average value to produce an rms value of said power line frequency input signal.

2. An rms converter according to claim 1 wherein said power line signal has a frequency that is one of 50 Hertz and 60 Hertz.

3. An rms converter according to claim wherein said rms measurement period is substantially close to 50 milliseconds.

4. A method for calculating rms values of a power line signal, comprising:
(a) digitally sampling said power line signal to obtain digital samples;
(b) squaring said digital samples in a squaring circuit to produce squared digital samples;
(c) averaging said squared digital samples over an rms measurement period to produce an average value wherein said rms measurement period spans an integer number of cycles of said squared digital samples; and
(d) taking a square root of said average value to produce said rms values.

5. A method for calculating rms values of a power line signal according to claim 4 wherein said power line signal has a frequency that is one of 50 Hertz and 60 Hertz.

6. A method for calculating rms values of a power line signal according to claim 5 wherein said rms measurement period is substantially close to 50 milliseconds.

7. A measurement instrument for obtaining fast rms measurements of a power line signal, comprising:
(a) a sampling system coupled to said power line signal to produce digital samples of said power line signal;
(b) an rms converter coupled to said sampling system to receive said digital samples over an rms measurement period to produce said rms value of said power line signal wherein said rms measurement period spans a minimum integer number of cycles of the square of said power line signal;
(c) a microprocessor for receiving said rms values from said rms converter according to said rms measurement period; and
(d) a display coupled to said microprocessor for receiving and displaying said rms values.

8. A measurement instrument for obtaining fast rms measurements of a power line signal according to claim 7, said rms converter comprising:
(a) a squaring circuit for receiving said digital samples of said power line signal to produce squared digital samples;
(b) an averaging circuit coupled to said squaring circuit to provide an average value of said squared digital samples over said rms measurement period; and
(c) a square root circuit for calculating the square root of said average value to produce said rms value of said power line signal.

9. A measurement instrument for obtaining fast rms measurements of a power line signal according to claim 7 wherein said power line signal has a frequency that is one of 50 Hertz and 60 Hertz.

10. A measurement instrument for obtaining fast rms measurements of a power line signal according to claim 7 wherein said rms measurement period is substantially close to 50 milliseconds.

11. A device for calculating rms values of a signal of a known frequency comprising means for performing rms calculations over a predetermined measurement period corresponding to an integer number of cycles of said signal.

12. A device as claimed in claim 11 for calculating rms values of two or more signals of known frequencies wherein the measurement period is the lowest common multiple of the periods of the signals.
